# EUROPEAN PATENT APPLICATION

(11) **EP 4 841 344 A1**
(43) Date of publication of application: **18.11.2026**
(21) Application number: 26176929.3
(22) Date of filing: 06.05.2026
(51) Int. Cl.: G03F 1/22, G03F 1/60

(54) **PHOTOMASK BLANK SUBSTRATE, PHOTOMASK BLANK SUBSTRATE SET, AND METHODS FOR MANUFACTURING THESE**

(30) Priority: 16.05.2025 JP 2025082681
(71) Applicant: SHIN-ETSU CHEMICAL CO., LTD., Chiyoda-ku, Tokyo 1000005 (JP)
(72) Inventor: SUGIYAMA, Tomoaki, Joetsu-shi, 9428601 (JP); HARADA, Daijitsu, Joetsu-shi, 9428601 (JP)
(74) Representative: Mewburn Ellis LLP

(57) **Abstract**

A photomask blank substrate has two main surfaces consisting of a first main surface and a second main surface each having a square shape with sides of 152 mm. When, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm is set, flatness of the strip-shaped region is 10 nm or less.

It is possible to provide a photomask reducing a shift of a transfer position during exposure and capable of achieving favorable transfer performance.

## Description

### TECHNICAL FIELD

The present invention relates to a photomask blank substrate which is a raw material of a photomask used for photolithography, particularly, a photomask blank substrate and a photomask blank substrate set consisting of two photomask blank substrates, which are suitable for photolithography using extreme ultraviolet (EUV) light as exposure light, and methods for manufacturing these.

### BACKGROUND

In recent years, as AI and IoT attract attention, arithmetic processing of enormous data is required, and accordingly, speeding up and power saving of arithmetic processing are required. In order to meet this demand, it is required to improve performance of an IC chip, and in general, miniaturization of a circuit is adopted as an effective means.

For miniaturization of a circuit, higher NA (higher numerical aperture), shorter wavelength of exposure light, and the like are mainly adopted, but in recent years, EUV lithography (EUVL) using EUV light has been put into practical use.

In EUVL, a photomask (exposure mask) is one of important elements, and it is extremely important to improve flatness of a photomask original plate (photomask blank) substrate in order to implement accurate exposure. As a method for manufacturing a normal substrate, double-sided simultaneous polishing is mainly used, but by only double-sided simultaneous polishing, favorable flatness that can be used for EUVL cannot be obtained. In order to achieve high flatness, it is necessary to correct flatness according to a surface shape by polishing one surface at a time, and for this, a local processing technique such as local etching or local polishing is used. Local processing is a method for causing the entire substrate to approach a flat substrate by removing a relatively protruding portion of a main surface of the substrate. In addition, by using a wavefront correction function of an exposure apparatus, a surface shape of a photomask can be optically corrected, and the photomask can be used as an optically high flat photomask.

In a conventional optical system, a pattern formed in a rectangular region of 104 mm × 132 mm on a photomask is equally reduced in the orthogonal directions of the surface (is reduced at an equal magnification in the x- and y-directions) and transferred to a range of 26 mm × 33 mm on a silicon wafer.

On the other hand, in recent years, a high NA is required also for EUVL, and an anamorphic lens is adopted as an optical system. In this case, a pattern formed in a rectangular region of 104 mm × 132 mm on a photomask is asymmetrically transferred to a range of 26 mm × 16.5 mm on a silicon wafer. Since only a half field can be transferred with one photomask, by transferring a pattern connected to a previously transferred pattern with another photomask, a full field pattern is formed.

In this case, it is necessary to precisely join the patterns of half fields without a shift of a transfer position, and as a technique therefor, a technique called stitching has been intensively studied. By stitching, it is becoming possible to join the patterns without errors even if the patterns are fine patterns. However, there are many technical problems left in stitching, and it is also required to minimize a shift of a transfer position caused by a photomask.

JP-A 2011-141536 (Patent Document 1) discloses a photomask glass substrate in which a portion corresponding to a holding surface of an exposure machine of the glass substrate has no distortion, in which flatness of two strip-shaped regions located in a range located between 2 mm and 10 mm inside from each of two opposing sides among sides forming a peripheral edge of a surface of a square-shaped substrate where a holding portion of the photomask is located and excluding portions of 2 mm from both ends of each side in a length direction is set to a predetermined value or less.

JP-A 2017-44758 (Patent Document 2) describes an EUVL mask blank glass substrate suitable for EUVL using an EUV exposure apparatus projection system using an anamorphic lens. In this EUVL mask blank glass substrate, by specifying an angle of a local slope in a reduction direction and a ratio thereof, it is possible to suppress an influence on roughness (LER) of an edge of a pattern formed on a wafer, the roughness being caused by exposure with different reduction ratios in an x direction and a y direction.

### Citation List

Patent Document 1: JP-A 2011-141536
Patent Document 2: JP-A 2017-44758
Patent Document 3: JP-A 2010-194705

### DISCLOSURE OF INVENTION

However, the flatness of the photomask glass substrate described in JP-A 2011-141536 (Patent Document 1) cannot cope with EUVL. In addition, even in the EUVL mask blank glass substrate described in JP-A 2017-44758 (Patent Document 2), the shift of the transfer position cannot be sufficiently suppressed only by considering the local surface shape. Furthermore, in both JP-A 2011-141536 (Patent Document 1) and JP-A 2017-44758 (Patent Document 2), a surface shape in a region that affects stitching of a main surface is not considered.

The present invention has been made in view of the above circumstances, and an object of the present invention is to provide a photomask blank substrate and a photomask blank substrate set that provide a photomask sufficiently suppressing a shift of a transfer position and capable of implementing favorable stitching in exposure using a photomask, particularly in exposure with high NA EUVL, and a method capable of manufacturing these with high productivity.

In order to apply stitching in exposure with high NA EUVL, it is necessary to consider a surface shape in a region that affects stitching. In order to implement favorable stitching, the present inventors have focused on a surface shape of a stitching target region of a photomask, particularly a surface shape of a stitching target region of a substrate used for a photomask blank which is a raw material of a photomask.

In order to solve the above problems, the present inventors have intensively made studies on a photomask blank substrate for a photomask to which stitching is applied, and as a result, have found that flatness of a stitching target region, which is a parameter affecting a shift of a transfer position, is important. Specifically, the present inventors have found that, in a photomask blank substrate having two main surfaces each having a square shape having one side of 152 mm and the other side of 152 mm, on the first main surface, in a rectangular region having a center at an intersection of diagonal lines of the first main surface, a short side of 104 mm, and a long side of 132 mm, the short side being parallel to a side of the first main surface, flatness of a strip-shaped region having the short side of the rectangular region as one side is important in a photomask blank substrate for a photomask to which stitching is applied.

In addition, the present inventors have found that the above problems can be solved by
(1) in a case of one photomask blank substrate, a photomask blank substrate in which flatness of a strip-shaped region having a rectangular shape having one short side or each of both short sides of the rectangular region as one side, a long side of 104 mm, and a short side of 1 to 2 mm is favorable, or
(2) in a case of a photomask blank substrate set consisting of two photomask blank substrates, a photomask blank substrate set in which flatness of a composite surface having a rectangular shape having one side of 104 mm and the other side of 2 to 4 mm is favorable, the composite surface being formed by connecting a surface of a strip-shaped region of one photomask blank substrate and a surface of a strip-shaped region of the other photomask blank substrate such that reference surfaces of both surfaces overlap with each other. Furthermore, the present inventors have found that these can be manufactured with high productivity by performing local processing in consideration of flatness of the strip-shaped region or flatness of the composite surface in manufacturing the photomask blank substrate or the photomask blank substrate set, and have completed the present invention.

Therefore, the present invention provides a photomask blank substrate, a photomask blank substrate set, a method for manufacturing the photomask blank substrate, and a method for manufacturing the photomask blank substrate set, described below.
1. A photomask blank substrate having two main surfaces consisting of a first main surface and a second main surface each having a square shape having one side of 152 mm and the other side of 152 mm, wherein
   when, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm is set,
   flatness of the strip-shaped region is 10 nm or less.
2. The photomask blank substrate according to the item 1, wherein a ratio of the flatness of the strip-shaped region to flatness of the rectangular region is 0.3 or less.
3. The photomask blank substrate according to the item 1, wherein
   when two strip-shaped regions each having a rectangular shape having each of two short sides of the rectangular region as one side, a long side of 104 mm, and a short side of 1 to 2 mm are set in the rectangular region,
   flatness of each of the two strip-shaped regions is 10 nm or less.
4. The photomask blank substrate according to the item 3, wherein a ratio of the flatness of each of the two strip-shaped regions to flatness of the rectangular region is 0.3 or less.
5. The photomask blank substrate according to the item 1 or 3, wherein flatness of the rectangular region is 30 nm or less.
6. The photomask blank substrate according to the item 1 or 3, having a thickness of 6.35 mm.
7. A photomask blank substrate set consisting of two photomask blank substrates each having two main surfaces consisting of a first main surface and a second main surface each having a square shape having one side of 152 mm and the other side of 152 mm, wherein
   in each of the two photomask blank substrates,
   when, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm is set,
   flatness of a composite surface having a rectangular shape having one side of 104 mm and the other side of 2 to 4 mm is 10 nm or less, the composite surface being formed by connecting a surface of the strip-shaped region of one photomask blank substrate and a surface of the strip-shaped region of the other photomask blank substrate such that reference surfaces of both surfaces overlap with each other.
8. The photomask blank substrate set according to the item 7, wherein the photomask blank substrate has a thickness of 6.35 mm.
9. A method for manufacturing a photomask blank substrate having two main surfaces consisting of a first main surface and a second main surface each having a square shape having one side of 152 mm and the other side of 152 mm, the method including:
   a local processing step; and a finish polishing step subsequent to the local processing step, for the first main surface, wherein
   the local processing step includes:
      (A1) a step of setting, on the first main surface of a raw material substrate, in a rectangular region having a center at an intersection of diagonals of the first main surface, a short side of 104 mm, and a long side of 132 mm, the short side being parallel to a side of the first main surface, one or two strip-shaped regions each having a rectangular shape having one short side or each of both short sides of the rectangular region as one side, a long side of 104 mm, and a short side of 1 to 2 mm,
      (B1) a step of evaluating flatness of the one or two strip-shaped regions, and
      (C1) a step of locally processing the first main surface such that the flatness of the one or two strip-shaped regions is within a predetermined range.
10. The manufacturing method according to the item 9, further including (D1) a step of evaluating flatness of the one or two strip-shaped regions of the first main surface after being locally processed in the step (C1).
11. The manufacturing method according to the item 10, wherein when the flatness of the one strip-shaped region or the flatness of one or both of the two strip-shaped regions evaluated in the step (D1) is not within the predetermined range, the step (C1) or the steps (C1) and (D1) are performed again.
12. A method for manufacturing a photomask blank substrate set consisting of two photomask blank substrates each having two main surfaces consisting of a first main surface and a second main surface each having a square shape having one side of 152 mm and the other side of 152 mm, the method including:
   a local processing step; and a finish polishing step subsequent to the local processing step, for the first main surface in one or both of the two photomask blank substrates, wherein
   the local processing step includes:
      (A2) a step of, in each of two raw material substrates,
      setting, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm;
      (B2) a step of evaluating flatness of a composite surface having a rectangular shape having one side of 104 mm and the other side of 2 to 4 mm, the composite surface being formed by connecting a surface of the strip-shaped region of one photomask blank substrate and a surface of the strip-shaped region of the other photomask blank substrate such that reference surfaces of both surfaces overlap with each other; and
      (C2) a step of locally processing one or both of the first main surfaces such that the flatness of the composite surface is within a predetermined range.
13. The manufacturing method according to the item 12, further including (D2) a step of evaluating the flatness of the composite surface after being locally processed in the step (C2).
14. The manufacturing method according to the item 13, wherein when the flatness of the composite surface evaluated in the step (D2) is not within the predetermined range, the step (C2) or the steps (C2) and (D2) are performed again.
15. The manufacturing method according to the item 9 or 12, wherein the photomask blank substrate has a thickness of 6.35 mm.

### ADVANTAGEOUS EFFECTS

According to the present invention, it is possible to provide a photomask reducing a shift of a transfer position at the time of exposure and capable of achieving favorable transfer performance, particularly capable of implementing favorable stitching in exposure using the photomask, particularly in exposure with high NA EUVL.

### BRIEF DESCRIPTION OF THE DRAWINGS

FIG. 1 is a plan view illustrating an example of a rectangular region and a strip-shaped region of a first main surface in a photomask blank substrate of the present invention; and
FIG. 2 is a plan view illustrating an example of a composite surface in which strip-shaped regions of two first main surfaces are connected in a photomask blank substrate set of the present invention.

### FURTHER EXPLANATIONS, OPTIONS AND PREFERENCES

Hereinafter, the present invention is described in detail.

The photomask blank substrate of the present invention has two main surfaces and a predetermined thickness. The main surface of the photomask blank substrate of the present invention has a square shape having one side of 152 mm and the other side of 152 mm. The thickness can be appropriately selected according to a size required for a photomask manufactured using the photomask blank substrate. In particular, a substrate having a square main surface of 152 mm x 152 mm and a thickness of 6.35 mm is preferable, which is referred to as a so-called 6025 substrate, and is a substrate having two rectangular main surfaces of 6 inches x 6 inches and a thickness of 0.25 inches.

A material of the photomask blank substrate of the present invention may be a conventionally used material, and is not particularly limited. However, in drawing a fine pattern, the photomask blank substrate is exposed to high-energy exposure light, and therefore TiO₂-doped quartz glass containing 3 to 10 wt% of TiO₂, the TiO₂-doped quartz glass having very high dimensional stability at high temperature, is suitably used. As the raw material substrate of the photomask blank substrate, a substrate synthesized, molded, and processed according to a conventional method can be used.

High flatness is required for the photomask blank substrate. This is because the higher the flatness, the easier the achievement of target exposure, and it can be said that a substrate having higher flatness is a photomask blank substrate more suitable for drawing a fine pattern. Two main surfaces of the photomask blank substrate include a first main surface on which an exposure pattern (such as a wiring pattern) is formed after film formation and a second main surface on which no exposure pattern is formed, and the second main surface is adsorbed and held by an exposure machine. The most advanced photomask is mainly a reflective mask, and an extremely high level flatness of the first main surface is required out of the first main surface and the second main surface. Therefore, in order to improve the flatness of the first main surface, various studies have been made on flattening by a local processing technique.

In order to meet a demand for further miniaturization of a circuit in recent years, EUVL also has a trend to have higher NA. Specifically, NA is increased from conventional NA 0.33 to NA 0.55, and in EUV exposure of NA 0.55, an anamorphic optical system different from a conventional one is adopted. Therefore, in NA 0.33, exposure is performed at the same magnification in an x direction and a y direction on a main surface of a photomask, but in NA 0.55, exposure is performed at different magnifications in the x direction and the y direction on the main surface of the photomask. As a result, while a circuit can be further miniaturized, a circuit can be formed only in a conventional half field by one exposure, and a full field is formed by two exposures using two photomasks. Therefore, a stitching technique for precisely joining circuit patterns in half fields has been developed. Stitching is a technique for precisely joining two interrupted circuits. Although it is difficult to precisely join extremely fine circuit patterns, in recent years, application in mass production is being achieved by progress of research and development.

A shift of a transfer position at the time of exposure is a factor that directly affects exposure quality. The shift (Image Placement Error: IPE) of the transfer position at the time of exposure can be expressed by the following formula: $IPE = d \times tanθ / M$
in which d represents flatness of an exposure surface of a photomask, θ represents an incident angle of exposure light, and M represents a reduction magnification, and
is inversely proportional to the reduction magnification.

In the optical system adopting an anamorphic lens, since a circuit pattern is asymmetrically reduced, the reduction magnification changes depending on a direction of a photomask, and IPE also changes. Since EUV light is emitted at an incident angle of a predetermined angle θ (for example, 6 degrees) inclined with respect to a direction orthogonal to a main surface of a substrate of a photomask, a positional shift of an exposure pattern on a wafer occurs depending on the shape of the surface of the photomask, and the smaller the IPE, the more favorable the exposure with a less positional shift. Therefore, also in a region that can be a target of stitching, IPE is smaller as the flatness is higher (a value of the flatness is smaller), which is advantageous for joining circuit patterns.

Regarding a relationship between IPE and the magnification M, M = 4 regardless of a direction of a photomask in a conventional EUV exposure machine of NA 0.33, but there are a direction in which M = 4 and a direction in which M = 8 in an EUV exposure machine of NA 0.55. Therefore, IPE varies depending on a direction of a photomask, and IPE is relatively largely affected in a direction in which the magnification M is lower.

Therefore, in order to evaluate IPE in consideration of a direction of a photomask, it is effective to consider each of the x direction and the y direction by separating the x direction and the y direction.

Here, if a direction in which the magnification M is low (M = 4) (a tangential direction of two half fields (a direction of one side of a main surface)) is represented by an x direction, a direction in which the magnification M is high (M = 8) (an arrangement direction of two half fields (a direction of the other side of the main surface)) is represented by a y direction, flatness in the x direction obtained by decomposing flatness d is represented by (dx), and flatness in the y direction obtained by decomposing the flatness d is represented by (dy), IPE (IPEx) in the x direction and IPE (IPEy) in the y direction can be expressed by the following formulas: $IPEx = dx \times tanθ / 4$ and $IPEy = dy \times tanθ / 8$ , and

IPE is expressed by the following formula: $IPE = {\left({\left(IPEx\right)}^{2}+{\left(IPEy\right)}^{2}\right)}^{0.5} .$

Therefore, since IPE is larger in the x direction in which the magnification M is low than in the y direction in which the magnification M is high, in a case where an influence of flatness of a region that can be a target of stitching is considered, it is necessary to place more importance on an influence of the flatness in the x direction than an influence of the flatness in the y direction. In addition, regarding a shift of the two half fields in the arrangement direction (a direction of the other side of the main surface), circuits can overlap with each other at a combining portion of the two half fields, and disconnection can be relatively easily avoided. However, a shift of the two half fields in the tangential direction (a direction of one side of the main surface) leads to a shortage of a line width at a combining portion of circuits, and if the shift exceeds the line width, disconnection occurs. Therefore, it is necessary to place more importance on an influence of the flatness in the tangential direction.

In the photomask blank substrate of the present invention, when, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm is set at a long side direction one end of the rectangular region, flatness of the strip-shaped region is 10 nm or less. A photomask including such a photomask blank substrate can implement favorable stitching in which a shift of a transfer position at the time of exposure is reduced in exposure with high-NA EUVL.

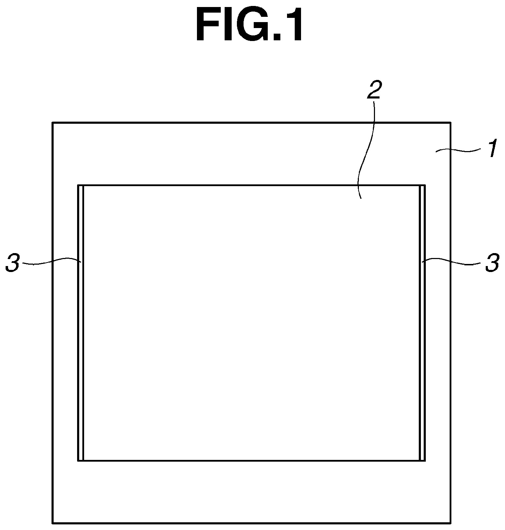

FIG. 1 is a plan view illustrating an example of the rectangular region and the strip-shaped region of the first main surface in the photomask blank substrate of the present invention. A rectangular region 2 has a short side of 104 mm and a long side of 132 mm, and the rectangular region 2 has a center at an intersection of diagonals of a first main surface 1 and is located at a position where a short side is parallel to a side of the first main surface (four sides of the rectangular region 2 are parallel to four sides of the first main surface 1). On the other hand, a strip-shaped region 3 has a rectangular shape having one short side or each of both short sides of the rectangular region 2 as one side, a long side of 104 mm, and a short side of 2 mm, and one strip-shaped region 3 or two strip-shaped regions 3 and 3 can be set in the rectangular region 2.

The strip-shaped region is a region that can be a target of stitching, and it is effective that the width of each of two half fields in a tangential direction (a direction of one side of the main surface) is the same as that of the rectangular region, and an arrangement direction of the two half fields (a direction of the other side of the main surface) is a part of a width of the rectangular region from a viewpoint of efficiently suppressing an influence of flatness in stitching while reliably reducing an influence of flatness in the tangential direction of the two half-fields (the direction of one side of the main surface). In the present invention, the length of the short side of the strip-shaped region is 1 to 2 mm, preferably 1 mm, more preferably 1.5 mm, and still more preferably 2 mm.

When two strip-shaped regions each having a rectangular shape having each of two short sides of the rectangular region as one side, a long side of 104 mm, and a short side of 1 to 2 mm are set at long side direction both ends in the rectangular region, flatness of each of the two strip-shaped regions is preferably 10 nm or less. A height map in surface shape measurement can be applied to the shape of the strip-shaped region. In this case, the two strip-shaped regions along one side located at both ends of the other side of the first main surface can be set as regions that can be targets of stitching. Note that the main surface may have two rectangular regions orthogonal to each other, and a strip-shaped region of one rectangular region may be a target, or strip-shaped regions of both rectangular regions may be targets.

The flatness of the strip-shaped region is 10 nm or less. In a case where the flatness of the strip-shaped region is 10 nm or less, a shift (IPE) of a transfer position at the time of exposure in the strip-shaped region that can be a target of stitching is about 0.26 nm or less if a magnification M satisfies M = 4 and an incident angle is 6 degrees, and is about 1.9% or less of an exposure wavelength 13.5 nm of EUV. The flatness of the strip-shaped region is preferably 7 nm or less, and more preferably 5 nm or less.

In the photomask blank substrate of the present invention, a ratio of the flatness of the strip-shaped region to the flatness of the rectangular region is preferably 0.3 or less (30% or less), and more preferably 0.25 or less (25% or less). In a case where two, three, or four strip-shaped regions are targeted, the ratio of the flatness of each of the strip-shaped regions to the flatness of the rectangular region is preferably 0.3 (30% or less) or less, and more preferably 0.25 or less (25% or less). If the ratio of the flatness is within such a range, the strip-shaped region that can be a target of stitching is significantly flatter than the entire rectangular region including the strip-shaped region, and the substrate is more suitable as a photomask blank substrate used for a photomask effective for exposure with high NA EUVL.

In the photomask blank substrate, not only the flatness of the strip-shaped region that can be a target of stitching but also the flatness of the entire main surface, particularly the flatness of the entire exposure target region of the main surface is important. The rectangular region corresponds to a range of the half field in EUV exposure of NA 0.55, and the flatness of the rectangular region affects IPE over the entire pattern formed in the half field. In the photomask blank substrate of the present invention, the flatness of the rectangular region (flatness of the entire rectangular region) is preferably 30 nm or less, and more preferably 25 nm or less. A height map in surface shape measurement can be applied to the shape of the rectangular region. If the flatness of the rectangular region is within such a range, not only the strip-shaped region that can be a target of stitching but also the entire exposure target region of the main surface is flat, and the substrate is more suitable as a photomask blank substrate used for a photomask effective for exposure with high NA EUVL. Note that the flatness of the rectangular region is ideally 0 nm, but is usually more than 0 nm.

In stitching, it is necessary to precisely join the half fields (circuits) to each other, and even if the flatness of the strip-shaped region of each of the two photomask blank substrates is favorable, the entire shape in which the two strip-shaped regions are joined is not sufficiently flat in some cases, and in these cases, there is a possibility that favorable stitching cannot be implemented. Therefore, it is useful to combine two photomask blank substrates that can implement favorable stitching, to join circuits of strip-shaped regions of two photomasks, and to perform exposure with high NA EUVL. Until now, it has not been studied whether or not stitching in a case where two photomask blank substrates are combined is favorable on the basis of the shapes of main surfaces thereof, particularly strip-shaped regions thereof.

The photomask blank substrate set of the present invention consists of two photomask blank substrates. In the photomask blank substrate set of the present invention, in each of the two photomask blank substrates, when, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm is set, flatness of a composite surface having a rectangular shape having one side of 104 mm and the other side of 2 to 4 mm is preferably 10 nm or less, the composite surface being formed by connecting a surface of the strip-shaped region of one photomask blank substrate and a surface of the strip-shaped region of the other photomask blank substrate such that reference surfaces of both surfaces overlap with each other. The flatness of the composite surface is preferably 7 nm or less, and more preferably 5 nm or less.

As for the strip-shaped regions to be connected, it is only required to connect any one strip-shaped region of one photomask blank substrate and any one strip-shaped region of the other photomask blank substrate. The composite surface consists of a surface of a strip-shaped region of one photomask blank substrate (one strip-shaped region) and a surface of a strip-shaped region of the other photomask blank substrate (the other strip-shaped region). This composite surface is a virtual surface obtained by combining the shapes of the two surfaces. The other side of the composite surface is preferably 2 mm, more preferably 3 mm, and still more preferably 4 mm.

When the surface of one strip-shaped region and the surface of the other strip-shaped region are connected, on the premise that stitching is applied, if necessary, one strip-shaped region or the other strip-shaped region is rotated by 90 degrees, 180 degrees, or 270 degrees along a reference surface, and a side of 104 mm on a side away from the center of the first main surface of one strip-shaped region and a side of 104 mm on a side away from the center of the first main surface of the other strip-shaped region are connected. A height map in surface shape measurement can be applied to the shape of the strip-shaped region. In addition, as the reference surface at the time of connecting the surfaces of the strip-shaped regions, a least square plane of the rectangular region of each of the two photomask blank substrates connecting the strip-shaped regions or a least square plane of each of the strip-shaped regions to be connected can be applied.

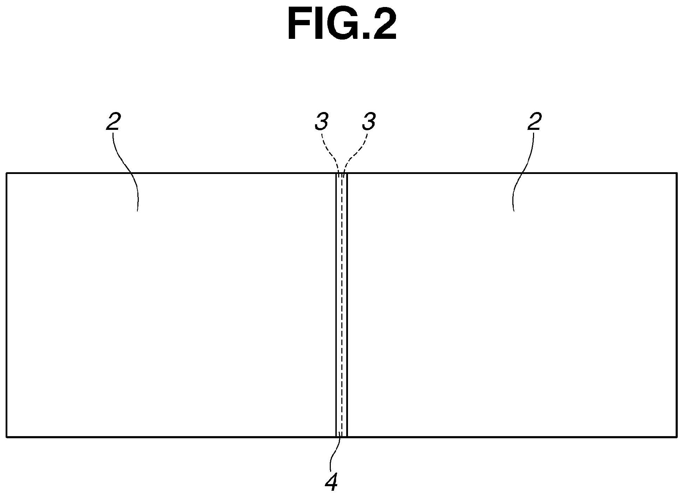

FIG. 2 is a plan view illustrating an example of a composite surface in which strip-shaped regions of two first main surfaces are connected in the photomask blank substrate set of the present invention. A composite surface 4 is formed by connecting the strip-shaped regions 3 and 3 in the rectangular regions 2 and 2 of the first main surfaces of the two photomask blank substrates at a side of 104 mm on a side away from the center of the first main surface of the strip-shaped region 3 of one photomask blank substrate and a side of 104 mm on a side away from the center of the first main surface of the strip-shaped region 3 of the other photomask blank substrate, and has a rectangular shape having one side of 104 mm and the other side of 4 mm.

In such a photomask blank substrate set, an overall shape obtained by joining strip-shaped regions that can be targets of stitching is sufficiently flat, a difference in shift of a transfer position at the time of exposure in the two strip-shaped regions that can be targets of stitching is small, and circuit patterns of two half fields can be more precisely joined. The photomask blank substrate set is suitable as a photomask blank substrate set used for a photomask effective for exposure with high NA EUVL.

Next, methods for manufacturing a photomask blank substrate and a photomask blank substrate set of the present invention are described. The method for manufacturing a photomask blank substrate of the present invention includes a local processing step, and a finish polishing step subsequent to the local processing step, for the first main surface. The method for manufacturing a photomask blank substrate of the present invention may include a local processing step, and a finish polishing step subsequent to the local processing step, for the second main surface.

In manufacture of a photomask blank substrate, a raw material substrate of the photomask blank substrate is prepared from a glass ingot before the local processing step. The raw material substrate of the photomask blank substrate can be usually prepared by first cutting out a glass ingot into a predetermined shape and subjecting the glass ingot to outer shape processing, and then polishing a main surface and an end surface. The polishing can be performed in several stages such as rough polishing, precision polishing, and ultra-precision polishing. This polishing can be performed using a polishing cloth and a polishing agent. The polishing agent is not particularly limited, but for example, an aqueous dispersion of cerium oxide having an average primary particle size of 10 to 100 nm or an aqueous dispersion of silica nanoparticles having an average primary particle size of 10 to 100 nm (colloidal silica aqueous dispersion) can be used.

The shape of a surface obtained only by local processing is not flat, and is usually a shape that cancels a change in the shape of the surface in finish polishing performed thereafter (generally a middle protruding shape (a shape in which a central portion of the main surface protrudes), a middle recessed shape (a shape in which the central portion of the main surface is recessed), or the like). Even if flatness of the shape of the surface obtained only by local processing is evaluated, the evaluation may be only deviated from an evaluation result of the shape of the main surface of a photomask blank substrate finally obtained. The change in the shape of the main surface caused by finish polishing performed under predetermined polishing conditions after local processing is reproducible. By grasping the change in the shape of the main surface after finish polishing under predetermined polishing conditions and applying the change to the shape of the main surface after local processing, the shape of the surface after the finish polishing performed under predetermined polishing conditions can be predicted. As a result, before the finish polishing, the shape of the surface obtained after the finish polishing can be evaluated at the stage of local processing, and the quality of the shape of the main surface obtained by the finish polishing can be evaluated. The change in the shape of the main surface after the finish polishing under predetermined polishing conditions can be obtained by processing and evaluating, in advance, a substrate having a surface shape similar to that of the substrate to be processed. The local processing step can be repeated until a predetermined shape is obtained.

In a method for manufacturing a photomask blank substrate of the present invention,
the local processing step preferably includes:
(A1) a step of setting, on the first main surface of the raw material substrate, in a rectangular region having a center at an intersection of diagonals of the first main surface, a short side of 104 mm, and a long side of 132 mm, the short side being parallel to a side of the first main surface, one or two strip-shaped regions each having a rectangular shape having one short side or each of both short sides of the rectangular region as one side, a long side of 104 mm, and a short side of 1 to 2 mm,
(B1) a step of evaluating flatness of the one or two strip-shaped regions, and
(C1) a step of locally processing the first main surface such that the flatness of the one or two strip-shaped regions is within a predetermined range.

In the step (A1), as for the strip-shaped region, on the first main surface of the raw material substrate, in a predetermined rectangular region, it is only required to set a predetermined region as the strip-shaped region. The rectangular region and the strip-shaped region can be set, for example, in a height map obtained by measuring the shape of the first main surface. In the present invention, the shapes of the first main surface, the rectangular region thereof, the strip-shaped region thereof, and the composite surface thereof can be measured by, for example, a laser interferometer.

In the step (B1), it is preferable to evaluate the flatness of the strip-shaped region not in the shape of the first main surface before finish polishing but in a shape obtained by adding a shape change of the surface by finish polishing to the shape of the first main surface after local processing. In this case, when the shape after local processing in the strip-shaped region of the first main surface is represented by S0 and the shape change of the surface by finish polishing is represented by ΔS,
a shape S0' of the first main surface after finish polishing represented by S0 + ΔS = S0' can be applied and evaluated in the strip-shaped region. As a result, the shape of the strip-shaped region obtained after finish polishing can be evaluated, and furthermore, the flatness can be evaluated (calculated) from the shape of the strip-shaped region. ΔS can be grasped by finish-polishing, in advance, another substrate having a surface shape similar to that of the substrate to be processed.

In the step (C1), the first main surface is locally processed such that the flatness of the strip-shaped region evaluated in the step (B1) is within a predetermined range. Local processing of the first main surface may be performed on the entire first main surface, only on the rectangular region, or only on the strip-shaped region.

In the present invention, in local processing, processing of selectively removing a relatively protruding portion is performed on the first main surface. Local processing can be performed by polishing using a polishing cloth and a polishing agent. The polishing agent is not particularly limited, but for example, an aqueous dispersion of cerium oxide having an average primary particle size of 10 to 100 nm or an aqueous dispersion of silica nanoparticles having an average primary particle size of 10 to 100 nm (colloidal silica aqueous dispersion) can be used. To local processing, a method such as Magneto Rheological Finishing (MRF) can also be applied.

The method for manufacturing a photomask blank substrate of the present invention preferably further includes (D1) a step of evaluating flatness of one or two strip-shaped regions of the first main surface after being locally processed in the step (C1).

In the step (D1), similarly to the step (B1), it is preferable to evaluate the flatness of the strip-shaped region not in the shape of the first main surface before finish polishing but in a shape obtained by adding a shape change of the surface by finish polishing to the shape of the first main surface after local processing. Also in this case, similarly to the step (B1), the shape S0' of the first main surface after finish polishing can be applied and evaluated in the strip-shaped region. As a result, the shape of the strip-shaped region obtained after finish polishing can be evaluated, and furthermore, the flatness can be evaluated (calculated) from the shape of the strip-shaped region.

Note that the flatness of the rectangular region can be evaluated in conjunction with the step (B1) or the step (D1). Also in this case, similarly to the strip-shaped region, it is preferable to evaluate the flatness of the rectangular region by the above-described method in a shape obtained by adding a shape change of the surface by finish polishing to the shape of the first main surface after local processing. As a result, the shape of the rectangular region obtained after finish polishing can be evaluated, and furthermore, the flatness can be evaluated (calculated) from the shape of the rectangular region. Furthermore, a ratio of the flatness of the strip-shaped region to the flatness of the rectangular region can be calculated from the flatness of the strip-shaped region and the flatness of the rectangular region.

In a case where the flatness of one strip-shaped region or both of the two strip-shaped regions evaluated in the step (D1), or the flatness of the strip-shaped region and the flatness of the rectangular region, and/or the ratio of the flatness of the strip-shaped region to the flatness of the rectangular region satisfy predetermined ranges, the finish polishing step can be performed. On the other hand, in a case where the flatness of one strip-shaped region or both of the two strip-shaped regions evaluated in the step (D1), or the flatness of the strip-shaped region and the flatness of the rectangular region, and/or the ratio of the flatness of the strip-shaped region to the flatness of the rectangular region are not within the predetermined ranges, the step (C1) or the steps (C1) and (D1) are preferably performed again. Note that the step (C1) or the steps (C1) and (D1) can be repeated until the flatness of the strip-shaped region or the flatness of the strip-shaped region and the flatness of the rectangular region and/or the ratio of the flatness of the strip-shaped region to the flatness of the rectangular region satisfy the predetermined ranges.

In the method for manufacturing a photomask blank substrate set of the present invention,
the local processing step preferably includes:
(A2) a step of setting, on the first main surface of each of two raw material substrates, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm,
(B2) a step of evaluating flatness of a composite surface having a rectangular shape having one side of 104 mm and the other side of 2 to 4 mm, the composite surface being formed by connecting a surface of one strip-shaped region and a surface of the other strip-shaped region such that reference surfaces of both surfaces overlap with each other; and
(C2) a step of locally processing one or both of the first main surfaces such that the flatness of the composite surface is within a predetermined range.

In the step (A2), as for the strip-shaped region, it is only required to set a predetermined region as the strip-shaped region in a predetermined rectangular region on the first main surface of the raw material substrate. The rectangular region and the strip-shaped region can be set, for example, in a height map obtained by measuring the shape of the first main surface. The shape of the first main surface can be measured by, for example, a laser interferometer.

In the step (B2), it is preferable to evaluate the flatness of the composite surface not in the shape of the first main surface before finish polishing but in a shape obtained by adding a shape change of the surface by finish polishing to the shape of the first main surface after local processing. In this case, when a shape after local processing on the composite surface of the first main surface is represented by S0 and a shape change of the surface by finish polishing is represented by ΔS,
a shape S0' of the first main surface after finish polishing represented by S0 + ΔS = S0' can be applied and evaluated in the composite surface. As a result, the shape of the composite surface obtained after finish polishing can be evaluated, and furthermore, the flatness can be evaluated (calculated) from the shape of the composite surface. ΔS can be grasped by finish-polishing, in advance, another substrate having a surface shape similar to that of the substrate to be processed.

In the step (C2), one or both of the first main surfaces are locally processed such that the flatness of the composite surface evaluated in the step (B2) is within a predetermined range. Local processing of the first main surface may be performed on the entire first main surface, only on the rectangular region, or only on the strip-shaped region.

The method for manufacturing a photomask blank substrate set of the present invention preferably further includes (D2) a step of evaluating flatness of the composite surface after being locally processed in the step (C2).

In the step (D2), similarly to the step (B2), it is preferable to evaluate the flatness of the composite surface not in the shape of the first main surface before finish polishing but in a shape obtained by adding a shape change of the surface by finish polishing to the shape of the first main surface after the local processing. Also in this case, similarly to the step (B2), the shape S0' of the first main surface after finish polishing can be applied and evaluated in the composite surface. As a result, the shape of the composite surface obtained after finish polishing can be evaluated, and furthermore, the flatness can be evaluated (calculated) from the shape of the composite surface.

In a case where the flatness of the composite surface evaluated in the step (D2) satisfies a predetermined range, the finish polishing step can be performed. On the other hand, when the flatness of the composite surface evaluated in the step (D2) is not within the predetermined range, the step (C2) or the steps (C2) and (D2) are preferably performed again. Note that the step (C2) or the steps (C2) and (D2) can be repeated until the flatness of the composite surface satisfies the predetermined range.

A defect level of a substrate surface obtained only by local processing may be insufficient particularly in a photomask blank substrate for state-of-the-art products, and in manufacturing of the photomask blank substrate, the finish polishing step is performed subsequent to the local processing step. The shapes of the first main surface of the photomask blank substrate obtained after finish polishing, the rectangular region thereof, the strip-shaped region thereof, and the composite surface thereof can also be evaluated as necessary, and the flatness can be evaluated (calculated). In this case, since finish polishing is performed, it is not necessary to consider the shape change (ΔS) of the surface due to finish polishing.

Whether or not the flatness of the strip-shaped region, the flatness of the rectangular region, and the ratio of the flatness of the strip-shaped region to the flatness of the rectangular region evaluated after finish polishing satisfy predetermined ranges can be evaluated. When the flatness of the strip-shaped region, the flatness of the rectangular region, and the ratio of the flatness of the strip-shaped region to the flatness of the rectangular region evaluated after finish polishing are not within the predetermined ranges, the local processing step can be performed again, and finish polishing can be performed again.

A photomask blank substrate and a photomask blank substrate set manufactured in this manner can achieve favorable stitching in which a shift of a transfer position at the time of exposure is reduced in exposure with high-NA EUVL.

### EXAMPLES

Hereinafter, the present invention is described specifically with reference to Examples, but the present invention is not limited to the following Examples.

### Example 1

Ten glass substrates (size and shape of each of first main surface and second main surface: square of 152 mm × 152 mm, thickness: 6.35 mm) made of SiO₂ and TiO₂ (TiO₂ concentration: about 7 wt%) were prepared. End surfaces (four surfaces other than main surface) of the glass substrate were subjected to chamfering processing and grinding processing, and further subjected to rough polishing and precision polishing with a polishing liquid containing cerium oxide abrasive grains.

Next, the ten glass substrates (substrate 1-1 to substrate 1-10) were set in a carrier of a double-side polishing apparatus to which a suede type soft polishing cloth was applied, and the first main surface and the second main surface were ultra-precisely polished using a polishing liquid of colloidal silica abrasive grains. After ultra-precision polishing, the glass substrates were washed with a washing liquid containing KOH to remove silica nanoparticles therefrom, and dried.

Next, on the first main surface, in a rectangular region having a center at an intersection of diagonals of the first main surface, a short side of 104 mm, and a long side of 132 mm, the short side being parallel to a side of the first main surface, two strip-shaped regions each having a rectangular shape having each of both short sides of the rectangular region as one side, a long side of 104 mm, and a short side of 2 mm were set ((A1) step).

Next, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated. Next, surface shapes of the portions of two strip-shaped regions were extracted from the surface shape (S0') of the rectangular region, and the flatness of the strip-shaped regions was evaluated (calculated) (step (B1)). Results thereof are presented in Table 1.

**Table 1**

| Substrate | Flatness [nm] | |
|---|---|---|
| | Strip-shaped region 1 | Strip-shaped region 2 |
| 1-1 | 38 | 42 |
| 1-2 | 78 | 91 |
| 1-3 | 45 | 76 |
| 1-4 | 88 | 35 |
| 1-5 | 58 | 90 |
| 1-6 | 73 | 53 |
| 1-7 | 71 | 69 |
| 1-8 | 34 | 85 |
| 1-9 | 84 | 85 |
| 1-10 | 69 | 37 |

In any of the ten glass substrates (substrates 1-1 to 1-10), the flatness of both of the two strip-shaped regions was not within a predetermined range (10 nm or less). Therefore, the strip-shaped regions were locally processed such that the flatness of the strip-shaped regions was within the predetermined range (step (C1)).

As a local processing apparatus, a local processing apparatus described in JP-A 2010-194705 (Patent Document 3) was used. Local processing using this apparatus polishes the entire surface of a substrate while controlling a moving speed of a fine polishing tool, and a target shape can be obtained by slowly moving the polishing tool in a relatively protruding portion and rapidly moving the polishing tool in a relatively recessed portion. As a processing tool of the local processing apparatus, wool felt buffs were used, and as a polishing slurry, silica nanoparticles (AJ-3540, manufactured by Nissan Chemical Corporation) mixed with a small amount of defoaming agent (Shin-Etsu Silicone KS-537, manufactured by Shin-Etsu Chemical Co., Ltd.) were used.

Next, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated. Next, surface shapes of the portions of two strip-shaped regions were extracted from the surface shape (S0') of the rectangular region, and the flatness of the strip-shaped regions was evaluated (calculated) (step (D1)). Results thereof are presented in Table 2.

**Table 2**

| Substrate | Flatness [nm] | |
|---|---|---|
| | Strip-shaped region 1 | Strip-shaped region 2 |
| 1-1 | 4 | 6 |
| 1-2 | 7 | 8 |
| 1-3 | 7 | 10 |
| 1-4 | 9 | 9 |
| 1-5 | 10 | 7 |
| 1-6 | 5 | 8 |
| 1-7 | 8 | 8 |
| 1-8 | 6 | 8 |
| 1-9 | 9 | 7 |
| 1-10 | 10 | 10 |

In each of the ten glass substrates (substrates 1-1 to 1-10), the flatness of both of the two strip-shaped regions was within the predetermined range (10 nm or less). Therefore, it was evaluated that the flatness of both of the two strip-shaped regions after finish polishing would be within the predetermined range, and the local processing step was terminated.

Next, the glass substrates after the local processing step were set in a carrier of a polishing apparatus to which a suede type soft polishing cloth was applied, and finish polishing was performed using a polishing liquid of colloidal silica. After polishing, the glass substrates were washed with a washing liquid containing KOH to remove colloidal silica therefrom, and dried, thus obtaining photomask blank substrates.

Next, the shape of the rectangular region of the first main surface was measured with a surface shape measurement apparatus (UltraFlat, manufactured by Tropel Corporation). Next, surface shapes of the portions of two strip-shaped regions were extracted from the surface shape of the rectangular region, and the flatness of the strip-shaped regions was evaluated (calculated). Results thereof are presented in Table 3.

**Table 3**

| Substrate | Flatness [nm] | |
|---|---|---|
| | Strip-shaped region 1 | Strip-shaped region 2 |
| 1-1 | 5 | 5 |
| 1-2 | 6 | 5 |
| 1-3 | 6 | 6 |
| 1-4 | 6 | 6 |
| 1-5 | 7 | 6 |
| 1-6 | 6 | 7 |
| 1-7 | 7 | 8 |
| 1-8 | 6 | 8 |
| 1-9 | 8 | 8 |
| 1-10 | 8 | 10 |

In each of the ten photomask blank substrates (substrates 1-1 to 1-10), it was confirmed that the flatness of both of the two strip-shaped regions was within the predetermined range (10 nm or less).

### Example 2

Five glass substrates (size and shape of first main surface and second main surface: square of 152 mm × 152 mm, thickness: 6.35 mm) made of SiO₂ and TiO₂ (TiO₂ concentration: about 7 wt%) were prepared. End surfaces (four surfaces other than main surface) of the glass substrate were subjected to chamfering processing and grinding processing, and further subjected to rough polishing and precision polishing with a polishing liquid containing cerium oxide abrasive grains.

Next, the five glass substrates (substrate 2-1 to substrate 2-5) were set in a carrier of a double-side polishing apparatus to which a suede type soft polishing cloth was applied, and the first main surface and the second main surface were ultra-precisely polished using a polishing liquid of colloidal silica abrasive grains. After ultra-precision polishing, the glass substrates were washed with a washing liquid containing KOH to remove silica nanoparticles therefrom, and dried.

Next, on the first main surface, in a rectangular region having a center at an intersection of diagonals of the first main surface, a short side of 104 mm, and a long side of 132 mm, the short side being parallel to a side of the first main surface, two strip-shaped regions each having a rectangular shape having each of both short sides of the rectangular region as one side, a long side of 104 mm, and a short side of 2 mm were set ((A1) step).

Next, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated. Next, surface shapes of the portions of two strip-shaped regions were extracted from the surface shape (S0') of the rectangular region, and the flatness of the strip-shaped regions was evaluated (calculated) (step (B1)). In addition, flatness of the rectangular region was evaluated (calculated) from the surface shape (S0') of the rectangular region, and a ratio of the flatness of the strip-shaped region to the flatness of the rectangular region was calculated. Results thereof are illustrated in Table 4.

**Table 4**

| Substrate | Flatness [nm] | | Flatness ratio [%] | |
|---|---|---|---|---|
| | Strip-shaped region 1 | Strip-shaped region 2 | Strip-shaped region 1 | Strip-shaped region 2 |
| 2-1 | 54 | 33 | 30 | 18 |
| 2-2 | 48 | 59 | 26 | 32 |
| 2-3 | 53 | 71 | 34 | 46 |
| 2-4 | 35 | 79 | 25 | 56 |
| 2-5 | 58 | 69 | 32 | 38 |

In any of the five glass substrates (substrates 2-1 to 2-5), the flatness of both of the two strip-shaped regions was not within the predetermined range (10 nm or less), and the ratio of the flatness of the strip-shaped region to the flatness of the rectangular region was not within a predetermined range (0.3 or less (30% or less)) in one or both of the two strip-shaped regions. Therefore, the rectangular region including the strip-shaped regions was locally processed such that the flatness of the strip-shaped region and the ratio of the flatness of the strip-shaped region to the flatness of the rectangular region were within the predetermined ranges (step (C1)).

As a local processing apparatus, a local processing apparatus described in JP-A 2010-194705 (Patent Document 3) was used. Local processing using this apparatus polishes the entire surface of a substrate while controlling a moving speed of a fine polishing tool, and a target shape can be obtained by slowly moving the polishing tool in a relatively protruding portion and rapidly moving the polishing tool in a relatively recessed portion. As a processing tool of the local processing apparatus, wool felt buffs were used, and as a polishing slurry, silica nanoparticles (AJ-3540, manufactured by Nissan Chemical Corporation) mixed with a small amount of defoaming agent (Shin-Etsu Silicone KS-537, manufactured by Shin-Etsu Chemical Co., Ltd.) were used.

Next, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated. Next, surface shapes of the portions of two strip-shaped regions were extracted from the surface shape (S0') of the rectangular region, and the flatness of the strip-shaped regions was evaluated (calculated) (step (D1)). In addition, flatness of the rectangular region was evaluated (calculated) from the surface shape (S0') of the rectangular region, and a ratio of the flatness of the strip-shaped region to the flatness of the rectangular region was calculated. Results thereof are illustrated in Table 5.

**Table 5**

| Substrate | Flatness [nm] | | Flatness ratio [%] | |
|---|---|---|---|---|
| | Strip-shaped region 1 | Strip-shaped region 2 | Strip-shaped region 1 | Strip-shaped region 2 |
| 2-1 | 9 | 7 | 30 | 23 |
| 2-2 | 7 | 7 | 24 | 24 |
| 2-3 | 9 | 8 | 30 | 27 |
| 2-4 | 8 | 8 | 29 | 29 |
| 2-5 | 6 | 4 | 29 | 19 |

In each of the five glass substrates (substrates 2-1 to 2-5), the flatness of both of the two strip-shaped regions was within the predetermined range (10 nm or less), and the ratio of the flatness of the strip-shaped region to the flatness of the rectangular region was within the predetermined range (0.3 or less (30% or less)) in both of the strip-shaped regions. Therefore, it was evaluated that the flatness of both of the two strip-shaped regions after finish polishing and the ratio of the flatness of both of the two strip-shaped regions to the flatness of the rectangular region after finish polishing would be within the predetermined ranges, and the local processing step was terminated.

Next, the glass substrates after the local processing step were set in a carrier of a polishing apparatus to which a suede type soft polishing cloth was applied, and finish polishing was performed using a polishing liquid of colloidal silica. After polishing, the glass substrates were washed with a washing liquid containing KOH to remove colloidal silica therefrom, and dried, thus obtaining photomask blank substrates.

Next, the shape of the rectangular region of the first main surface was measured with a surface shape measurement apparatus (UltraFlat, manufactured by Tropel Corporation). Next, surface shapes of the portions of two strip-shaped regions were extracted from the surface shape of the rectangular region, and the flatness of the strip-shaped regions was evaluated (calculated). In addition, flatness was evaluated (calculated) from the surface shape of the rectangular region, and a ratio of the flatness of the strip-shaped region to the flatness of the rectangular region was calculated. Results thereof are illustrated in Table 6.

**Table 6**

| Substrate | Flatness [nm] | | Flatness ratio [%] | |
|---|---|---|---|---|
| | Strip-shaped region 1 | Strip-shaped region 2 | Strip-shaped region 1 | Strip-shaped region 2 |
| 2-1 | 8 | 6 | 30 | 22 |
| 2-2 | 8 | 8 | 28 | 28 |
| 2-3 | 8 | 7 | 28 | 24 |
| 2-4 | 7 | 7 | 26 | 26 |
| 2-5 | 5 | 5 | 24 | 24 |

In each of the five photomask blank substrates (substrates 2-1 to 2-5), it was confirmed that the flatness of both of the two strip-shaped regions was within the predetermined range (10 nm or less). In addition, in each of the five photomask blank substrates (substrates 2-1 to 2-5), it was confirmed that the ratio of the flatness of both of the two strip-shaped regions to the flatness of the rectangular regions was within the predetermined range (0.3 or less (30% or less)).

### Example 3

Five glass substrates (size and shape of first main surface and second main surface: square of 152 mm × 152 mm, thickness: 6.35 mm) made of SiO₂ and TiO₂ (TiO₂ concentration: about 7 wt%) were prepared. End surfaces (four surfaces other than main surface) of the glass substrate were subjected to chamfering processing and grinding processing, and further subjected to rough polishing and precision polishing with a polishing liquid containing cerium oxide abrasive grains.

Next, the five glass substrates (substrate 3-1 to substrate 3-5) were set in a carrier of a double-side polishing apparatus to which a suede type soft polishing cloth was applied, and the first main surface and the second main surface were ultra-precisely polished using a polishing liquid of colloidal silica abrasive grains. After ultra-precision polishing, the glass substrates were washed with a washing liquid containing KOH to remove silica nanoparticles therefrom, and dried.

Next, on the first main surface, in a rectangular region having a center at an intersection of diagonals of the first main surface, a short side of 104 mm, and a long side of 132 mm, the short side being parallel to a side of the first main surface, two strip-shaped regions each having a rectangular shape having each of both short sides of the rectangular region as one side, a long side of 104 mm, and a short side of 2 mm were set ((A1) step).

Next, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated. Next, surface shapes of the portions of two strip-shaped regions were extracted from the surface shape (S0') of the rectangular region, and the flatness of the strip-shaped regions was evaluated (calculated) (step (B1)). In addition, the flatness of the rectangular region was evaluated (calculated) from the surface shape (S0') of the rectangular region. Results thereof are presented in Table 7.

**Table 7**

| Substrate | Flatness [nm] | | |
|---|---|---|---|
| | Strip-shaped region 1 | Strip-shaped region 2 | Rectangular region |
| 3-1 | 37 | 65 | 185 |
| 3-2 | 48 | 31 | 136 |
| 3-3 | 59 | 36 | 192 |
| 3-4 | 63 | 42 | 147 |
| 3-5 | 19 | 38 | 138 |

In any of the five glass substrates (substrates 3-1 to 3-5), the flatness of both of the two strip-shaped regions was not within the predetermined range (10 nm or less), and the flatness of the rectangular region was not within the predetermined range (30 nm or less). Therefore, the rectangular region including the strip-shaped regions was locally processed such that the flatness of the strip-shaped regions and the flatness of the rectangular region were within the predetermined ranges (step (C1)).

As a local processing apparatus, a local processing apparatus described in JP-A 2010-194705 (Patent Document 3) was used. Local processing using this apparatus polishes the entire surface of a substrate while controlling a moving speed of a fine polishing tool, and a target shape can be obtained by slowly moving the polishing tool in a relatively protruding portion and rapidly moving the polishing tool in a relatively recessed portion. As a processing tool of the local processing apparatus, wool felt buffs were used, and as a polishing slurry, silica nanoparticles (AJ-3540, manufactured by Nissan Chemical Corporation) mixed with a small amount of defoaming agent (Shin-Etsu Silicone KS-537, manufactured by Shin-Etsu Chemical Co., Ltd.) were used.

Next, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated. Next, surface shapes of the portions of two strip-shaped regions were extracted from the surface shape (S0') of the rectangular region, and the flatness of the strip-shaped regions was evaluated (calculated) (step (D1)). In addition, the flatness of the rectangular region was evaluated (calculated) from the surface shape (S0') of the rectangular region. Results thereof are presented in Table 8.

**Table 8**

| Substrate | Flatness [nm] | | |
|---|---|---|---|
| | Strip-shaped region 1 | Strip-shaped region 2 | Rectangular region |
| 3-1 | 10 | 6 | 24 |
| 3-2 | 9 | 8 | 29 |
| 3-3 | 6 | 6 | 28 |
| 3-4 | 6 | 7 | 26 |
| 3-5 | 7 | 5 | 27 |

In any of the five glass substrates (substrates 3-1 to 3-5), the flatness of both of the two strip-shaped regions was within the predetermined range (10 nm or less), and the flatness of the rectangular region was within the predetermined range (30 nm or less). Therefore, it was evaluated that the flatness of both of the two strip-shaped regions after finish polishing and the flatness of the rectangular region after finish polishing would be within the predetermined ranges, and the local processing step was terminated.

Next, the glass substrates after the local processing step were set in a carrier of a polishing apparatus to which a suede type soft polishing cloth was applied, and finish polishing was performed using a polishing liquid of colloidal silica. After polishing, the glass substrates were washed with a washing liquid containing KOH to remove colloidal silica therefrom, and dried, thus obtaining photomask blank substrates.

Next, the shape of the rectangular region of the first main surface was measured with a surface shape measurement apparatus (UltraFlat, manufactured by Tropel Corporation). Next, surface shapes of the portions of two strip-shaped regions were extracted from the surface shape of the rectangular region, and the flatness of the strip-shaped regions was evaluated (calculated). In addition, the flatness was evaluated (calculated) from the surface shape of the rectangular region. Results thereof are presented in Table 9.

**Table 9**

| Substrate | Flatness [nm] | | |
|---|---|---|---|
| | Strip-shaped region 1 | Strip-shaped region 2 | Rectangular region |
| 3-1 | 6 | 6 | 24 |
| 3-2 | 8 | 8 | 29 |
| 3-3 | 7 | 8 | 28 |
| 3-4 | 7 | 7 | 26 |
| 3-5 | 8 | 8 | 27 |

In each of the five photomask blank substrates (substrates 3-1 to 3-5), it was confirmed that the flatness of both of the two strip-shaped regions was within the predetermined range (10 nm or less). In addition, in each of the five photomask blank substrates (substrates 3-1 to 3-5), it was confirmed that the flatness of the rectangular region was within the predetermined range (30 nm or less).

### Example 4

Three glass substrate sets each consisting of two glass substrates (size and shape of first main surface and second main surface: square of 152 mm × 152 mm, thickness: 6.35 mm) made of SiO₂ and TiO₂ (TiO₂ concentration: about 7 wt%) were prepared. End surfaces (four surfaces other than main surface) of the glass substrate were subjected to chamfering processing and grinding processing, and further subjected to rough polishing and precision polishing with a polishing liquid containing cerium oxide abrasive grains.

Next, the six glass substrates of the three glass substrate sets (substrate sets 4-1 to 4-3) were set in a carrier of a double-side polishing apparatus to which a suede type soft polishing cloth was applied, and the first main surface and the second main surface were ultra-precisely polished using a polishing liquid of colloidal silica abrasive grains. After ultra-precision polishing, the glass substrates were washed with a washing liquid containing KOH to remove silica nanoparticles therefrom, and dried.

Next, in each of the two glass substrates of each of the glass substrate sets, on the first main surface, in a rectangular region having a center at an intersection of diagonals of the first main surface, a short side of 104 mm, and a long side of 132 mm, the short side being parallel to a side of the first main surface, two strip-shaped regions having a rectangular shape having short sides of the rectangular region as sides, a long side of 104 mm, and a short side of 2 mm were set ((A2) step).

Next, in each of the two glass substrates of each of the glass substrate sets, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated.

Next, in each of the two glass substrates of each of the glass substrate sets, the surface shape of the portion of one strip-shaped region was extracted from the surface shape (S0') of the rectangular region, and the surface of one strip-shaped region and the surface of the other strip-shaped region were connected such that least square planes of the rectangular regions of the two photomask blank substrates to be connected overlapped with each other, thereby setting a composite surface having a rectangular shape having one side of 104 mm and the other side of 4 mm. The composite surface is a virtual surface obtained by connecting a side of 104 mm on a side away from a center of the first main surface of one strip-shaped region and a side of 104 mm on a side away from a center of the first main surface of the other strip-shaped region, of the two glass substrates. Next, flatness of the composite surface was evaluated (calculated) (step (B2)). Results thereof are presented in Table 10.

**Table 10**

| Substrate set | Flatness [nm] |
|---|---|
| | Composite surface |
| 4-1 | 31 |
| 4-2 | 27 |
| 4-3 | 52 |

In any of the three glass substrate sets (substrate sets 4-1 to 4-3), the flatness of the composite surface was not within the predetermined range (10 nm or less). Therefore, the strip-shaped regions of both of the two glass substrates were locally processed such that the flatness of the composite surface was within the predetermined range (step (C2)).

As a local processing apparatus, a local processing apparatus described in JP-A 2010-194705 (Patent Document 3) was used. Local processing using this apparatus polishes the entire surface of a substrate while controlling a moving speed of a fine polishing tool, and a target shape can be obtained by slowly moving the polishing tool in a relatively protruding portion and rapidly moving the polishing tool in a relatively recessed portion. As a processing tool of the local processing apparatus, wool felt buffs were used, and as a polishing slurry, silica nanoparticles (AJ-3540, manufactured by Nissan Chemical Corporation) mixed with a small amount of defoaming agent (Shin-Etsu Silicone KS-537, manufactured by Shin-Etsu Chemical Co., Ltd.) were used.

Next, in each of the two glass substrates of each of the glass substrate sets, the shape (S0) of the rectangular region of the first main surface was measured by a surface shape measurement apparatus (UltraFlat, manufactured by Tropel Corporation), a substrate having a surface shape similar to that of a substrate to be processed was processed in advance, a surface shape change (ΔS) by finish polishing measured in advance was added, and a surface shape (S0') obtained by adding the surface shape change by finish polishing was calculated. Next, a surface shape of the portion of the strip-shaped region was extracted from the surface shape (S0') of the rectangular region, a composite surface was set, and the flatness of the composite surface was evaluated (calculated) (step (D2)).

Results thereof are presented in Table 11.

**Table 11**

| Substrate set | Flatness [nm] |
|---|---|
| | Composite surface |
| 4-1 | 4 |
| 4-2 | 6 |
| 4-3 | 10 |

In each of the three glass substrate sets (substrate sets 4-1 to 4-3), the flatness of the composite surface was within the predetermined range (10 nm or less). Therefore, it was evaluated that the flatness of the composite surface after finish polishing would be within the predetermined range, and the local processing step was terminated.

Next, in each of the two glass substrates of each of the glass substrate sets, the glass substrate after the local processing step was set in a carrier of a polishing apparatus to which a suede type soft polishing cloth was applied, and finish polishing was performed using a polishing liquid of colloidal silica. After polishing, the glass substrate was washed with a washing liquid containing KOH to remove colloidal silica therefrom, and dried, thus obtaining a photomask blank substrate set.

Next, the shape of the rectangular region of the first main surface was measured with a surface shape measurement apparatus (UltraFlat, manufactured by Tropel Corporation). Next, a surface shape of the portion of the strip-shaped region was extracted from the surface shape of the rectangular region, a composite surface was set, and the flatness of the composite surface was evaluated (calculated). Results thereof are presented in Table 12.

**Table 12**

| Substrate set | Flatness [nm] |
|---|---|
| | Composite surface |
| 4-1 | 5 |
| 4-2 | 7 |
| 4-3 | 10 |

In each of the three photomask blank substrate sets (substrate sets 4-1 to 4-3), it was confirmed that the flatness of the composite surface was within the predetermined range (10 nm or less).

In the photomask blank substrates and the photomask blank substrate sets obtained in Examples, flatness of a region that can be a target of stitching is extremely favorable, and in exposure with high NA EUVL, it is possible to provide a photomask that reduces a shift of a transfer position at the time of exposure, capable of implementing favorable stitching, and having high exposure performance. It is possible to expect to obtain a favorable exposure result from such a photomask.

## Claims

1. A photomask blank substrate having two main surfaces consisting of a first main surface and a second main surface each having a square shape having one side of 152 mm and the other side of 152 mm, wherein
when, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm is set,
flatness of the strip-shaped region is 10 nm or less.

2. The photomask blank substrate according to claim 1, wherein a ratio of the flatness of the strip-shaped region to flatness of the rectangular region is 0.3 or less.

3. The photomask blank substrate according to claim 1 or 2, wherein
when two strip-shaped regions each having a rectangular shape having each of two short sides of the rectangular region as one side, a long side of 104 mm, and a short side of 1 to 2 mm are set in the rectangular region,
flatness of each of the two strip-shaped regions is 10 nm or less.

4. The photomask blank substrate according to claim 3, wherein a ratio of the flatness of each of the two strip-shaped regions to flatness of the rectangular region is 0.3 or less.

5. The photomask blank substrate according to any one of claims 1 to 4, wherein flatness of the rectangular region is 30 nm or less.

6. The photomask blank substrate according to any one of claims 1 to 5, having a thickness of 6.35 mm.

7. A photomask blank substrate set consisting of two photomask blank substrates each having two main surfaces consisting of a first main surface and a second main surface each having a square shape having one side of 152 mm and the other side of 152 mm, wherein
in each of the two photomask blank substrates,
when, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm is set,
flatness of a composite surface having a rectangular shape having one side of 104 mm and the other side of 2 to 4 mm is 10 nm or less, the composite surface being formed by connecting a surface of the strip-shaped region of one photomask blank substrate and a surface of the strip-shaped region of the other photomask blank substrate such that reference surfaces of both surfaces overlap with each other.

8. The photomask blank substrate set according to claim 7, wherein the photomask blank substrate has a thickness of 6.35 mm.

9. A method for manufacturing a photomask blank substrate having two main surfaces consisting of a first main surface and a second main surface each having a square shape having one side of 152 mm and the other side of 152 mm, the method comprising:
a local processing step; and a finish polishing step subsequent to the local processing step, for the first main surface, wherein
the local processing step includes:
(A1) a step of setting, on the first main surface of a raw material substrate, in a rectangular region having a center at an intersection of diagonals of the first main surface, a short side of 104 mm, and a long side of 132 mm, the short side being parallel to a side of the first main surface, one or two strip-shaped regions each having a rectangular shape having one short side or each of both short sides of the rectangular region as one side, a long side of 104 mm, and a short side of 1 to 2 mm,
(B1) a step of evaluating flatness of the one or two strip-shaped regions, and
(C1) a step of locally processing the first main surface such that the flatness of the one or two strip-shaped regions is within a predetermined range.

10. The manufacturing method according to claim 9, further comprising (D1) a step of evaluating flatness of the one or two strip-shaped regions of the first main surface after being locally processed in the step (C1).

11. The manufacturing method according to claim 10, wherein when the flatness of the one strip-shaped region or the flatness of one or both of the two strip-shaped regions evaluated in the step (D1) is not within the predetermined range, the step (C1) or the steps (C1) and (D1) are performed again.

12. A method for manufacturing a photomask blank substrate set consisting of two photomask blank substrates each having two main surfaces consisting of a first main surface and a second main surface each having a square shape having one side of 152 mm and the other side of 152 mm, the method comprising:
a local processing step; and a finish polishing step subsequent to the local processing step, for the first main surface in one or both of the two photomask blank substrates, wherein
the local processing step includes:
(A2) a step of, in each of two raw material substrates,
setting, on the first main surface, in a rectangular region having a center at an intersection of diagonals of the first main surface, a short side of 104 mm, and a long side of 132 mm, the short side being parallel to a side of the first main surface, a strip-shaped region having a rectangular shape having one short side of the rectangular region as one side, a long side of 104 mm, and a short side of 1 to 2 mm;
(B2) a step of evaluating flatness of a composite surface having a rectangular shape having one side of 104 mm and the other side of 2 to 4 mm, the composite surface being formed by connecting a surface of the strip-shaped region of one photomask blank substrate and a surface of the strip-shaped region of the other photomask blank substrate such that reference surfaces of both surfaces overlap with each other; and
(C2) a step of locally processing one or both of the first main surfaces such that the flatness of the composite surface is within a predetermined range.

13. The manufacturing method according to claim 12, further comprising (D2) a step of evaluating the flatness of the composite surface after being locally processed in the step (C2).

14. The manufacturing method according to claim 13, wherein when the flatness of the composite surface evaluated in the step (D2) is not within the predetermined range, the step (C2) or the steps (C2) and (D2) are performed again.

15. The manufacturing method according to any one of claims 9 to 14, wherein the photomask blank substrate has a thickness of 6.35 mm.
